Europäisches Patentamt

(19) European Patent Office

Office européen des brevets

(11) Publication number: **0 025 362**
**B1**

(12) **EUROPEAN PATENT SPECIFICATION**

(45) Date of publication of patent specification: 01.04.87

(51) Int. Cl.⁴: **H 01 S 3/19, H 01 L 33/00**

(21) Application number: 80303169.9

(22) Date of filing: 10.09.80

(54) A semiconductor light emitting device.

(30) Priority: 11.09.79 JP 116320/79

(43) Date of publication of application:
18.03.81 Bulletin 81/11

(45) Publication of the grant of the patent:
01.04.87 Bulletin 87/14

(84) Designated Contracting States:
DE FR GB

(56) References cited:
FR-A-2 348 589

APPLIED PHYSICS LETTERS, vol. 31, no. 1, 1st
July 1977, pages 45-47, New York, USA L.
FIGUEROA et al.: "Inverted-ridge-waveguide
double-heterostructure injection laser with
current and lateral optical confinement"

APPLIED PHYSICS LETTER, vol. 35, no. 3,
August 1979, pages 232-234, New York, USA H.
NISHI et al.: "Self-aligned structure
InGaAsP/InP DH lasers"

(73) Proprietor: FUJITSU LIMITED
1015, Kamikodanaka Nakahara-ku
Kawasaki-shi Kanagawa 211 (JP)

(72) Inventor: Fujiwara, Takao
6-5, Kamitsuruma 3-chome
Sagamihara-shi Kanagawa, 228 (JP)
Inventor: Hanamitsu, Kiyoshi
2-14-12, Misono Sagamihara-shi
Kanagawa, 228 (JP)
Inventor: Ohsaka, Sigeo
100-A-101, Idasanmai-cho Nakahara-ku
Kawasaki-shi Kanagawa, 211 (JP)
Inventor: Ishikawa, Hiroshi
No. 3-10-18, Todoroki Setagaya-ku
Tokyo, 158 (JP)
Inventor: Takagi, Nobuyuki
1-3-908, Wakabadai Asahi-ku
Yokohama-shi Kanagawa, 241 (JP)
Inventor: Segi, Katsuharu
473-4-201, Hisasue Takatsu-ku
Kawasaki-shi Kanagawa, 213 (JP)

(74) Representative: Bedggood, Guy Stuart et al
Haseltine Lake & Co. Hazlitt House 28
Southampton Buildings Chancery Lane
London WC2A 1AT (GB)

Courier Press, Leamington Spa, England.

## Description

This invention relates to a semiconductor light emitting device, and more particularly to a semiconductor laser which is suitable for use as a light source, for example, for optical communication.

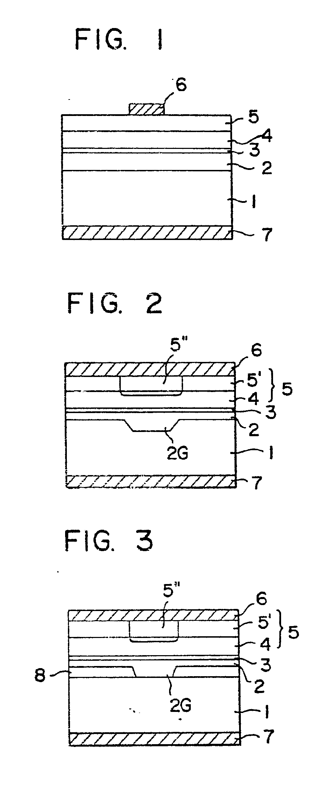

There has been previously proposed a semiconductor laser as shown in Fig. 1 of the accompanying drawings which is a schematic sectional view showing principal parts of the laser.

In Fig. 1, 1 is an n-type GaAs substrate; 2 is an n-type $Ga_{0.7}Al_{0.3}As$ clad layer; 3 is a GaAs active layer; 4 is a p-type $Ga_{0.7}Al_{0.3}As$ clad layer; 5 is a p-type GaAs layer; 6 is an electrode on the positive side of the laser; and 7 is an electrode on the negative side of the laser.

In the semiconductor laser shown in Fig. 1, as a current increases, its light emitting region spreads out, resulting in a lateral oscillation mode becoming unstable. The reason for this is that there is no mechanism for stabilizing the lateral mode, other than a difference in the gain of a current distribution.

In order to overcome this defect, there has been proposed a semiconductor laser of such a construction as shown in Fig. 2 of the accompanying drawings, which is a schematic sectional view showing principal parts of the laser, and in which parts corresponding to those in Fig. 1 are identified by the same reference numerals.

The semiconductor laser of Fig. 2 differs from the semiconductor laser of Fig. 1 in that the clad layer 2 has a projecting portion 2G and in that the clad layer 2 outside of the projecting portion 2G is relatively thin. The cap layer 5 is composed of an n-type GaAs portion 5' and a p-type GaAs region 5'' for setting therein a current path.

In the semiconductor laser of Fig. 2, light emitted from the active layer 3 leaks out of the clad layer 2 outside of the projecting portion 2G and is absorbed and reflected by the n-type GaAs substrate 1. That is, the effective refractive index in parts outside of a stripe region defined by the presence of region 5'' and portion 2G, that is, parts except portion 2G, is varied and a loss in those parts is large, by which means the oscillation region is restricted to the parts corresponding to the projecting portion 2G to set up an optical guide mechanism, stabilizing the lateral oscillation mode.

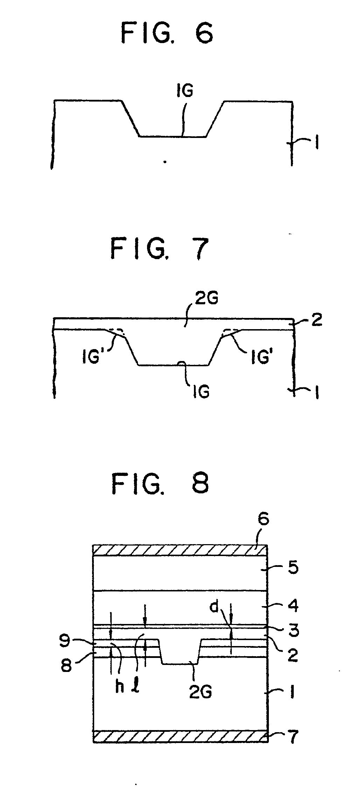

The semiconductor laser of Fig. 2, however, poses some problems in terms of its manufacture. The clad layer 2 is formed on substrate 1 in which a recess is made prior to the formation of the clad layer 2, and since the clad layer 2 is very thin except at its projecting portion 2G, there is a possibility that the clad layer 2 will sag at a position corresponding to the recess in the substrate 1 and consequently at a position corresponding to the projecting portion 2G, causing the active layer 3 to be curved when formed. If the clad layer 2 is formed relatively thickly, to avoid this problem, then the light guide effect would be lost. Another problem is a difficulty in maintaining a desired shape for the recess formed in the substrate 1 for obtaining the projecting portion 2G. That is, in a case in which a recess 1G is formed in the substrate 1 first, as shown in Fig. 6, and then the clad layer 2 is formed by liquid phase epitaxy on the substrate 1, as shown in Fig. 7, the desired edge shape of the recess 1G (indicated by broken lines in Fig. 7) may be rounded of into the form of gentle slopes 1G'. The reason for this is as follows. The edge of the recess 1G is high in surface energy but other parts are low in surface energy, and when the growth solution makes contact with the substrate 1, the edge of the recess 1G is liable to be etched back by the solution. In a case in which such a gentle slope 1G' is formed and the projecting portion 2G of the clad layer 2 conforms to the recess 1G, the light emitting region becomes wider as a current flows, making it impossible to maintain unity of the oscillation mode. Still another problem is that it is very difficult to form the p-type GaAs region 5'' for setting up a current path and the projecting portion 2G in alignment with each other. If they are not aligned, the amount of current which does not contribute to oscillation and which is therefore ineffective, increases, with a resultant increase in a threshold current and an operating current, introducing non-uniformity into the light emission in the lateral direction and a change in the light emitting region.

Fig. 3 of the accompanying drawings, which is a schematic sectional view, illustrates principal parts of another previously proposed semiconductor laser which is different in construction from the semiconductor laser of Fig. 2. The former differs from the latter in that the n-type GaAs substrate 1 is formed flat, that is, without having a recess therein; a p-type GaAs current preventing layer 8 is formed on the substrate 1; and after a groove is formed in the layer 8, the clad layer 2 is grown on the layer 8 to form the projecting portion 2G in the groove in layer 8.

This semiconductor laser has the same defects as mentioned above in connection with Fig. 2 except in regard to current confinement. In addition, the p-type GaAs current preventing layer 8 considered to be advantageous over the semiconductor laser of Fig. 2 is of little or no use in practice. In order for the laser device of Fig. 3 to serve as a device having an optical guide mechanism, it is also necessary that the p-type GaAs current preventing layer 8 absorb light of the active layer 3 leaking out of the clad layer 2. In the current preventing layer 8 electrons and holes are generated by absorbed light; the holes alone are gradually stored. This is equivalent to the application of a bias voltage to the current preventing layer 8 in a forward direction with respect to the n-type GaAs substrate 1 and the n-type GaAlAs clad layer 2, and when the holes have been stored the current preventing layer 8 is biased to a potential substantially equal to a diffusion potential between the substrate 1 and the clad layer 2. In a case in which the current rejecting layer 8 is not sufficiently thick as compared with the diffusion length of minority carriers, electrons in the substrate 1 flow into the clad layer 2 through the current preventing layer 8, so that the current preventing layer 8 does not perform its function. The diffusion length of minority carriers depends on carrier concentration and it is 1 to 3 µm in the case of GaAs and, in order to ensure that the current preventing layer performs its function, the thickness of the layer must be 5 to 10 times the diffusion length of minority carriers. It is difficult to select the thickness of the current preventing layer 8 in the range up to 10 µm and to form the groove of 1 to 6 µm depth, for example, by means of etching. Moreover, it is difficult to select the distance between the active layer 3 and the current preventing layer 8 at a maximum as 0.4 µm and to form the active layer 3 flat. If the current preventing layer 8 and the active layer 3 are spaced apart by a distance of 1 µm or more, so as to prevent the current preventing layer 8 from absorbing light, the layer 8 always performs the current preventing function but the optical guide function is lost.

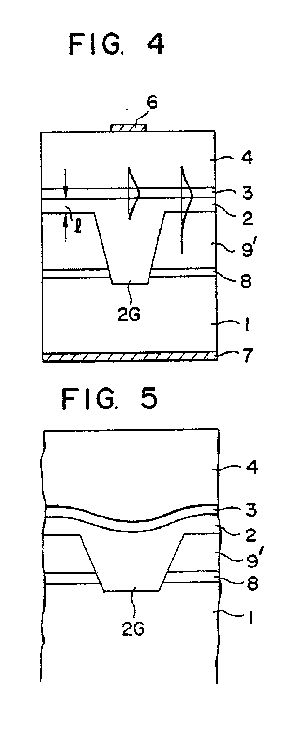

Furthermore, a conventional semiconductor laser shown in Fig. 4 of the accompanying drawings, which is a schematic sectional view, has also been proposed. In Fig. 4, parts corresponding to those in Figs. 1 to 3 are identified by the same reference numerals.

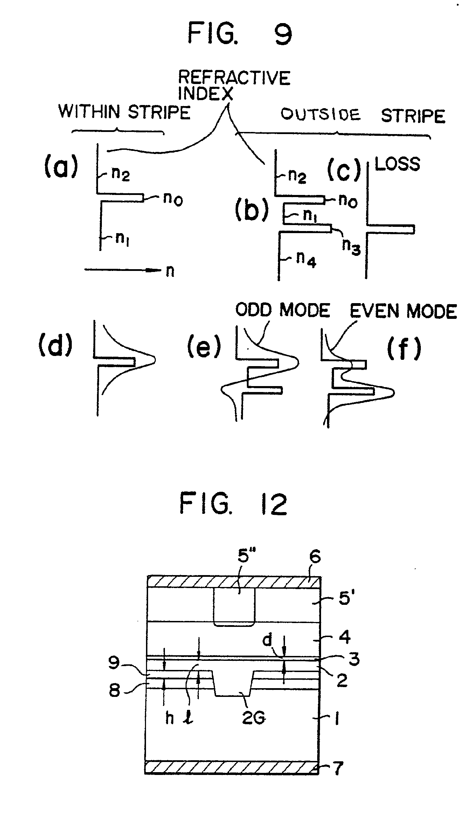

In Fig. 4, 8 is a p-type GaAlAs current preventing layer; and 9' is a p- or n-type GaAs layer.

One of defects of this semiconductor laser is an increase in threshold current. That is, since use is made of what is called a loss guide system in which light is absorbed by the GaAs layer 9' on the outside of the stripe and is consequently guided in the stripe alone, the threshold current increases. Another defect is that the active layer 3 is formed with a hollow and cannot be made flat, as shown in Fig. 5 of the accompanying drawings, which is a schematic sectional view. The reason is that since the value *l* shown in Fig. 4 must be selected to be, for example, 0.3 µm or less for guiding light, the active layer 3 is exposed directly to the influence of the groove. Still another defect is that since the GaAs layer 9' is thick, the gentle slope 1G' described previously in respect of Figs. 6 and 7 is produced as in the cases of the other previously proposed devices.

At present, many studies are being made in an effort to overcome the abovementioned defects of previously proposed devices. For example, it has been proposed to form the clad layer 2 with a thickness of up to 0.3 µm excepting the projecting portion 2G, and to so define the degree of supersaturation of the growth solution, the cooling rate, and the growing time of the active layer 3 and so forth, as to grow the layer 3 flat. However, the manufacture of the semiconductor laser under such restricted conditions involves difficulties in terms of control. For example, an increase in the degree of supersaturation of the growth solution suppresses the etching-back of the edge of the recess during the formation of the clad layer but causes an increase in growth speed; accordingly, the clad layer tends to become thick, thereby to increase the distance between the active layer and the substrate, resulting in loss of optical guide function.

Attention is directed to the documents cited in the European Search Report of this application, i.e. FR—A—2 348 589 and Applied Physics Letters Vol. 31, No. 1, pp 45—47 and Vol. 35, No. 3, pp 232—234.

The present invention can provide a semiconductor laser which is free from the abovementioned defects of previously proposed lasers, which is equipped with a current confinement region setting function effective at all times, and an optical guide function unobtainable with the previously proposed lasers and which is capable of stable oscillation in the lateral mode and which is easy to manufacture.

According to the present invention there is provided a semiconductor light emitting device which comprises an active layer, a first clad layer joined to one side of the active layer and having a larger forbidden band width than the active layer, a second clad layer joined to the other side of the active layer having a larger forbidden band width than the active layer being opposite in conductivity type to the first clad layer and having a projecting portion formed on the opposite side thereof from the active layer, and a current preventing layer between the second clad layer and a substrate or base layer of the device and opposite in conductivity type to the second clad layer and the substrate or base layer, which substrate or base layer is joined to the projecting portion of the second clad layer,

characterised in that

an etch back preventive layer less than 0.4 µm thick is joined to the second clad layer, except for the said projecting portion, on the said opposite side of the second clad layer, and the current preventing layer is joined on one side to the etch back preventive layer and on the other to the substrate or base layer,

and in that

the current preventing layer has a forbidden band width larger than that of the etch back preventing layer and larger than that of the substrate or base layer, and the etch back preventive layer has a forbidden band width less than that of the second clad layer,

and in that

the thickness of the projecting portion of the second clad layer is sufficiently large as to confine light from the active layer between it and the substrate or base layer, and the thickness of the second clad layer excepting the projecting portion is sufficiently small as to allow light from the active layer to penetrate the etch back preventing layer.

Reference is made, by way of example, to the accompanying drawings, in which:—

Fig. 1 is a sectional view showing principal parts of a previously proposed laser device;

Fig. 2 is a sectional view showing principal parts of another previously proposed laser device;

Fig. 3 is a sectional view showing principal parts of a further previously proposed laser device;

Fig. 4 is a sectional view showing principal parts of yet another previously proposed laser device;

Fig. 5 is a sectional view showing principal parts of still a further previously proposed laser device;

Fig. 6 is a sectional view for assistance in explanation of a defect found in a previously proposed laser device;

Fig. 7 is a sectional view for assistance in explanation of a defect found in a previously proposed laser device;

Fig. 8 is a sectional view explanatory of principal parts of an embodiment of the present invention;

Fig. 9 shows schematic diagrams illustrating the relationships between refractive indexes and laser operation mode;

Fig. 10 is a graph illustrating relationships between effective refractive index and loss;

Fig. 11 is a graph illustrating the relationship between dimensions $l$ and $h$ shown in Fig. 8;

Fig. 12 is a sectional view explanatory of principal parts of another embodiment of the present invention; and

Fig. 13 is a sectional view explanatory of principal parts of still another embodiment of the present invention.

Fig. 8 is a sectional view illustrating principal parts of a semiconductor light emitting device embodying the present invention. In Fig. 8, parts corresponding to those mentioned in connection with the foregoing drawings are identified by the same reference numerals.

In the embodiment illustrated in Fig. 8, an etchback preventive layer 9 is formed in addition to current preventing layer 8 and the forbidden band width of a predetermined layer is selected to be a certain value.

The etch-back preventive layer 9 is an n-type GaAlAs layer and the amount of aluminium contained therein is held at a certain value, as described later.

Letting the forbidden band widths of respective parts be represented as follows:

Substrate 1: $E_1$ (a sixth semiconductor layer)

Current preventing layer 8: $E_2$ (a fifth semiconductor layer)

Etch-back preventive layer 9: $E_3$ (a fourth semiconductor layer)

Clad layer 2 (including the projecting portion 2G): $E_4$ (a third semiconductor layer)

Active layer 3: $E_5$ (a first semiconductor layer)

Clad layer 4: $E_6$ (a second semiconductor layer)

Cap layer 5: $E_7$

the forbidden band width $E_2$ is selected larger than $E_1$ and $E_3$. The substrate 1 is identical in conductivity type with the clad layer 2, whereas the current preventing layer 8 and the clad layer 4 are opposite in conductivity type to the substrate 1.

The current suppressing action of the device of Fig. 8 is as follows:

When light emitted from the active layer 3 is absorbed by the etch-back preventive layer 9, holes and electrons are produced in the layer 9 and some of them flow into the current preventing layer 8 to bias it effectively in a forward direction with respect to the substrate 1. Since the forbidden band width of the current preventing layer 8 is larger than that of the substrate 1, however, majority carriers in the substrate 1 cannot flow into the current preventing layer 8. Accordingly, the majority carriers in the substrate 1 flow into the active layer 3, passing through the projecting portion 2G of the clad layer 2, by which a current can be controlled to flow only in a stripe region defined by the projecting portion 2G.

Next, a description will be given of the optical guide function in the device of Figure 8.

Fig. 9 shows refractive index and loss distributions in the stripe region defined by the projecting portion 2G and outside of the stripe region in the direction vertical to layer junctions in Fig. 8. Fig. 9(a) shows the distribution of the refractive indexes of the layers 2 to 4 in the stripe region, Fig. 9(b) shows the distribution of the refractive indexes of the layers 2 to 4, and layers 8 and 9 outside the stripe region, and Fig. 9(c) shows the loss distributions. In Figs. 9(a) to 9(c), $n_0$, $n_1$, $n_2$, $n_3$, $n_4$ are, respectively, the refractive indices of the active layer 3, the clad layer 4, the clad layer 2, the etch back preventive layer 9 and the current preventing layer 8.

On account of the refractive index distributions shown, an even and an odd mode exist outside of the stripe region, as seen in Figs. 9(e) and (f), and light in the stripe region is coupled mainly with the odd mode. In the odd mode, by reducing the thickness $h$ of the etch-back preventive layer 9, the propagation constant is made small as compared with that for the mode in the stripe region (see Fig. 9(d)) even if the thickness $l$ of clad layer 2 is large. By this means, the effective refractive index outside of the stripe region is made smaller than the effective refractive index in the stripe region. As a consequence, light is confined to the stripe region.

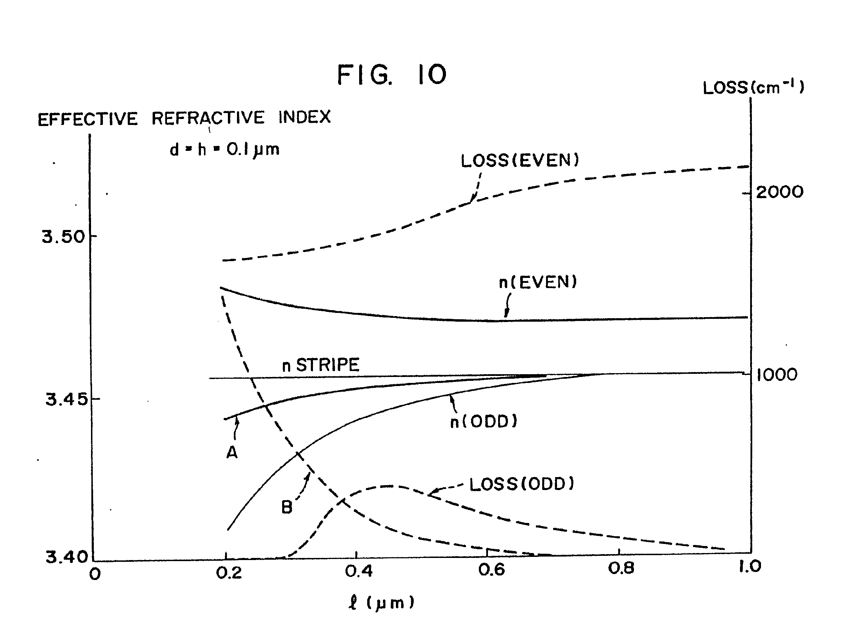

Fig. 10 is a graph showing the effective refractive index and the loss calculated from the odd mode and the mode propagation constant in the stripe region, with $d=h=0.1$ μm, $d$ being the thickness of the active layer 3. The refractive indexes of the respective layers were selected as follows:

| | |
|---|---|
| Refractive index of active layer 3 | $n_0=3.63$ |
| Refractive index of clad layer 4 | $n_1=3.44$ |
| Refractive index of clad layer 2 | $n_2=3.39$ |
| Refractive index of etch-back preventive layer 9 | $n_3=3.64$ |
| Refractive index of current preventing layer 8 | $n_4=3.44$ |

In general, it can be said that a refractive index difference necessary for controlling the lateral mode is required to be a relative effective refractive index difference of about $3\times10^{-3}$. In Fig. 10, the solid-line curve A and the broken line curve B respectively indicate the effective refractive index and the loss in the device described previously in connection with Figs. 4 and 5. In this device, when the thickness $l$ of the clad layer 2 is selected to be 0.3 μm, the effective refractive indexes inside and outside of the stripe region are substantially equal. On the other hand, the loss outside of the stripe region is as large as 800 cm$^{-1}$, which is in excess of 500 cm$^{-1}$ which is an amount of loss necessary for guiding light. Accordingly, light is guided on the basis of the loss on the outside of the stripe region. In contrast thereto, in the present invention, as will be evident from Fig. 10, when the thickness $l$ of the clad layer 2 is in the range of 0.2 to 0.4 μm, the loss is smaller than 450 cm$^{-1}$ and no light is guided on the basis of the loss on the outside the stripe region. In other words, as the thickness $l$ of the clad layer 2 decreases, the effective refractive index on the outside of the stripe region is reduced to increase the effective refractive index difference between the inside and the outside of the stripe region, by which light is guided.

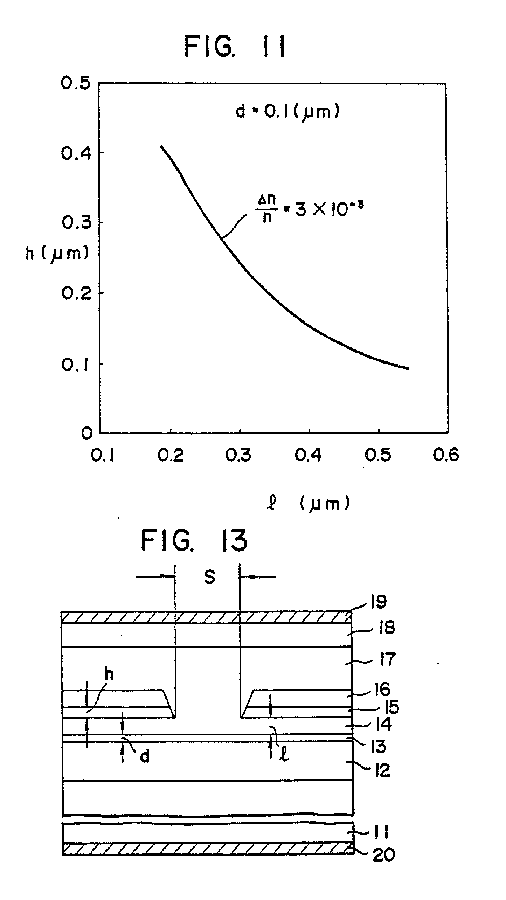

Thus, the device described previously in connection with Figs. 4 and 5 utilizes the loss on the outside of the stripe region for guiding light, whereas in the present invention optical guiding is dependent on the effective refractive index difference between the inside and the outside of the stripe region. In the present invention, a change in the effective refractive index is large with respect to the thickness $l$ of the clad layer 2, and in the case where the thickness $h$ of the etch-back preventive layer 9 is 0.1 μm, even if the thickness $l$ of the clad layer 2 is 0.5 μm, the odd mode provides a relative effective refractive index difference of $3\times10^{-3}$. Accordingly, even if the thickness $l$ of the clad layer 2 is large, effective confinement of light is possible. The fact that the thickness $l$ of the clad layer 2 can be made large enables the active layer 3 to be formed flat, and hence is effective for enhancement of production yield in terms of crystal growth. With the thickness $h$ of the etch-back preventive layer 9 selected large, the optical guide mechanism becomes similar to that of the conventional device shown in Fig. 2; namely with $h=0.4$ μm, the optical guide mechanism is substantially the same as that of the prior device. Therefore, the thickness $h$ of the etch-back preventive layer 9 should not be made so large. The relationship between $h$ and $l$ necessary for obtaining the relative effective refractive index of $3\times10^{-3}$ is such as shown in Fig. 11.

Next, a description will be given of the prevention of etch back in the present embodiment.

In the present embodiment, the etch-back preventive layer 9 is provided, as shown in Fig. 8. In concrete terms, the etch-back preventive layer 9 is a $Ga_{1-x}Al_xAs$ layer, where $0.1>x>0$. In the previous proposals mentioned above, no attention is paid to a difference between GaAs and $Ga_{1-x}Al_xAs$ containing such a slight amount of aluminium as indicated by the abovesaid condition. In our experiments in which a GaAs substrate having formed therein a recess, and a $Ga_{1-x}Al_xAs$ $(0.1>x>0)$ substrate having similarly formed therein a recess, were subjected to liquid phase epitaxial growth using an equilibrium solution, a supersaturated solution having a supersaturation degree of 0.5 [°C] and a supersaturated solution having a supersaturation degree of 1 [°C], the recess of the GaAs substrate remained unchanged, without causing etch back, only in the case of the solution having the supersaturation degree of 1 [°C], whereas the recess of the $Ga_{1-x}Al_xAs$ substrate remained unchanged in the cases of all the solutions and the so-called sag was not caused. This was also found in the case where, after forming a $Ga_{1-x}Al_xAs$ $(0.1>x>0)$ layer on a GaAs substrate and then forming a recess in the layer to extend down to the substrate, the GaAs substrate was subjected to the liquid phase epitaxial growth using each of the abovesaid solutions. Only in the case where the thickness $h$ of the etch-back preventive layer 9 is selected to be smaller than 0.4 μm, even if no aluminium is added, is the etch back very slight; namely, the edge of the recess in the etch-back preventive layer 9 is rounded only slightly. Further, since the mixed crystal ratio of aluminium is large, the current preventing layer 8 is not etched back and does not substantially change its entire configuration.

Next, a description will be given of the manufacture of the semiconductor laser of the embodiment shown in Fig. 8.

A p-type $Ga_{0.7}Al_{0.3}As$ current preventing layer 8 is formed by the liquid phase epitaxy to a thickness of 0.5 to 1 μm on a silicon-doped GaAs substrate 1 which has a (100) plane and an electron concentration of $1\times10^{17}$ to $5\times10^{18}$. Then, an n-type $Ga_{0.99}Al_{0.01}As$ etch-back preventive layer 9 is similarly formed to a thickness of 0.1 to 0.4 μm on the current preventing layer 8.

By known photolithography techniques, a groove 2 to 10 μm wide, such as is shown in Fig. 6, is formed in the substrate assembly to extend down to the substrate 1.

After this, an n-type $Ga_{0.7}Al_{0.3}As$ clad layer 2, a p-type $Ga_{0.95}Al_{0.05}As$ active layer 3, a p-type $Ga_{0.65}Al_{0.35}As$ clad layer 4 and a p-type GaAs cap layer 5 are formed by liquid phase epitaxy to thicknesses of 0.2 to 0.5 μm (in the portion of the layer 2 indicated by $l$), 0.1 μm, 1μm and 1 μm, respectively, on the substrate assembly.

Thereafter, electrodes 6 and 7 are deposited by a known method on the cap layer 5 and the underside of the substrate 1, respectively. Then, the assembly is cleaved into individual chips about 300 μm long.

When the groove was 6 μm wide, the laser thus obtained exhibited a threshold current density of 1.2 KA/cm$^2$ at room temperature. Further, the laser oscillated stably in the lateral mode of the least order and no kink appeared in the current vs. optical output characteristic. Moreover, when the etch-back preventive layer 9 was formed thin, an excellent characteristic was obtained even if the thickness $l$ of the clad layer 2 was about 0.5 μm.

In the embodiment of Fig. 8, the thickness of the etch-back preventive layer 9 is selected to be 0.1 to 0.4 μm and the value x to be 0.01. The reason for selecting the thickness of the layer 9 in such a range is as follows: With a thickness less than 0.1

μm, the layer is too thin and difficult to form. And the thickness of the layer 9 with which it is possible to obtain a relative effective refractive index difference of $3 \times 10^{-3}$ when the thickness $l$ of the clad layer 2 is 0.2 μm, which is a feasible minimum value, is 0.4 μm. With a thickness exceeding this value, the abovesaid specific refractive index difference cannot be obtained and the lateral mode is unstable the value x is not limited specifically to 0.01 mentioned in the above embodiment and can be selected in the range of 0.1 to 0. If the value x exceeds 0.1, an aluminium oxide film becomes rigid and the crystal to be grown thereon does not become excellent.

Moreover, in the foregoing embodiment, the thickness of the clad layer 2 is selected to be 0.5 μm but this thickness can be selected in the range of 0.2 to 0.5 μm. With $l<0.2$ μm, the active layer 3 cannot be formed flat, and with $l>0.5$ μm, even if the etch-back preventive layer 9 is formed to the feasible minimum thickness, i.e. 0.1 μm, it is impossible to obtain the relative effective refractive index difference $3 \times 10^{-3}$ which is necessary for stabilizing the lateral mode.

Fig. 12 illustrates in section principal parts of another embodiment of the prevent invention. In Fig. 12 parts corresponding to those in Fig. 8 are marked with the same reference numerals.

This embodiment differs from the embodiment of Fig. 8 in that a cap layer 5′ is an n-type GaAs layer, and in that zinc Zn is introduced in the cap layer 5′ in a stripe pattern to form therein a p-type GaAs region. In this embodiment, a slight misalignment of the p-type GaAs region 5″ and the projecting portion 2G does not present such problems as were referred to previously with respect to the previously proposed devices shown in Figs. 2 and 3. The reason for this is that since the current preventing layer 8 in the present invention effectively performs its function at all times, the current path setting function is not required to be so strictly performed by the p-type GaAs region 5″. Accordingly, the manufacture of the device of this embodiment is not so difficult, as compared with the abovementioned previously proposed devices. In accordance with the present embodiment, when the groove was 6 μm wide, a threshold current density of 1.1 KA/cm² was obtained and the lateral oscillation mode was also stable.

Further, a modified form of the embodiment of Fig. 8 was produced and, in this case, the current preventing layer 8 was a p-type $Ga_{0.8}Al_{0.2}As$ layer and the same characteristics as those of the embodiment of Fig. 8 were obtained.

In the foregoing embodiments, so-called ternary compound semi-conductors are employed but of course, a quaternary compound can also be used.

Fig. 13 illustrates an example of a semiconductor laser using a quaternary compound. In Fig. 13, 11 is an n-type InP substrate (100 μm thick); 12 is an n-type InP layer (1.5 μm thick); 13 is an n-type InGaAsP active layer (whose thickness is indicated by $d$); 14 is a p-type InP layer (whose thickness is indicated by $l$); 15 is an n-type InGaAsP layer (whose thickness is indicated by $h$); 16 is an n-type InGaAsP (or InP) layer (1 μm thick); 17 is a p-type InP layer (1.5 μm thick); 18 is a p-type InGaAsP layer (1 μm thick); 19 is a Ti-Pt-Au electrode 20 is an Au-Ge-Ni electrode; and S is the width of a stripe. The thicknesses $d$, $l$ and $h$ are 0.04 to 0.2, 0.2 to 0.5 and 0.1 to 0.5 μm, respectively.

As will be appreciated from the foregoing description, according to the present invention, a current preventing layer and an etch-back preventive layer are provided in a semiconductor laser provided with a clad layer having a projecting portion for confining light from an active layer and a portion from which light leaks, and the forbidden band width and the conductivity type of each layer are specified. In this way, it is possible to provide a semiconductor laser having an excellent current limit function and optical guide function, and in addition, the semiconductor laser is easy to manufacture.

**Claims**

1. A semiconductor light emitting device which comprises an active layer (3, 13), a first clad layer (4) joined to one side of the active layer (3) and having a larger forbidden band width than the active layer (3), a second clad layer (2) joined to the other side of the active layer (3) having a larger forbidden band width than the active layer (3) being opposite in conductivity type to the first clad layer and having a projecting portion (2G) formed on the opposite side thereof from the active layer (3), and a current preventing layer (8) between the second clad layer (2) and a substrate or base layer (1) of the device and opposite in conductivity type to the second clad layer (2) and the substrate or base layer (1), which substrate or base layer (1) is joined to the projecting portion (2G) of the second clad layer (2),
characterised in that
an etch back preventive layer (9) less than 0.4 μm thick is joined to the second clad layer (2), except for the said projecting portion (2G), on the said opposite side of the second clad layer (2), and the current preventing layer (8) is joined on one side to the etch back preventive layer (9) and on the other to the substrate or base layer (1),
and in that
the current preventing layer (8) has a forbidden band width ($E_2$) larger than that ($E_3$) of the etch back preventive layer (9) and larger than that ($E_1$) of the substrate or base layer (1), and the etch back preventive layer (9) has a forbidden band width ($E_3$) less than that ($E_4$) of the second clad layer (2),
and in that
the thickness of the projecting portions (2G) of the second clad layer (2) is sufficiently large as to confine light from the active layer (3, 13) between it and the substrate or base layer (1), and the thickness of the second clad layer (2) excepting the projecting portion is sufficiently small as to allow light from the active layer (3) to penetrate the etch back preventive layer (9).

2. A semiconductor light emitting device according to claim 1, wherein the etch back preventive layer (9) is a $Ga_{1-x}Al_xAs$ $(0.1>x\geq0)$ layer.

3. A semiconductor light emitting device according to claim 1 or 2, wherein the thickness of the etch back preventive layer (9) is less than four times the thickness of the active layer (3).

4. A semiconductor light emitting device according to any preceding claim, wherein the thickness $h$ of the etch back preventive layer (9) is 0.1 µm or more.

5. A semiconductor light emitting device according to claim 4, wherein the thickness $l$ of the second clad layer (2) on the etch back preventive layer (9) is 0.2 to 0.5 µm.

## Patentansprüche

1. Licht emittierende Halbleitervorrichtung, die umfaßt:

eine aktive Schicht (3, 13), eine Auskleidungsschicht (4), die an einer Seite der aktiven Schicht (3) angefügt ist und eine größere verbotene Bandbreite als die aktive Schicht (3) hat, eine zweite Auskleidungsschicht (2), die an der anderen Seite der aktiven Schicht (3) angefügt ist und eine größere verbotene Bandbreite als die aktive Schicht (3) hat, von entgegengesetztem Leitfähigkeitstyp zu der ersten Auskleidungsschicht ist und einen vorspringenden Abschnitt (2G) hat, der auf der von der aktiven Schicht (3) abgewandten Seite gebildet ist, und eine Stromunterdrückungsschicht (8), zwischen der zweiten Auskleidungsschicht (2) und einer Substrat- oder Basisschicht (1) der Vorrichtung und von enntgegengesetztem Leitfähigkeitstyp zu der zweiten Auskleidungsschicht (2) und der Substrat- oder Basisschicht (1), welche Substrat- oder Basisschicht (1) an den vorspringenden Abschnitt (2G) der zweiten Auskleidungsschicht (2) angefügt ist,

dadurch gekennzeichnet, daß eine Rückätzungsverhinderungsschicht (9) von weniger als 0,4 µm Dicke an die zweite Auskleidungsschicht (2) angefügt ist, mit Ausnahme des genannten vorspringenden Abschnitts (2G), auf der genannten abgewandten Seite der zweiten Auskleidungsschicht (2), und die Stromunterdrückungsschicht (8) mit einer Seite an die Rückätzungsverhinderungschicht (9) und mit der anderen Seite an die Substrat- oder Basisschicht (1) angefügt ist,

und daß

die Stromunterdrückungsschicht (8) eine verbotene Bandbreite ($E_2$) hat, die größer als diejenige ($E_3$) der Rückätzungsverhinderungsschicht (9) und größer als diejenige ($E_1$) der Substrat- oder Basisschicht (1) ist, und die Rückätzungsverhinderungsschicht (9) eine verbotene Bandbreite ($E_3$) hat, die kleiner als diejenige ($E_4$) der zweiten Auskleidungsschicht (2) ist,

und daß

die Dicke des vorspringenden Abschnitts (2G) der zweiten Auskleidungsschicht (2) hinreichend groß ist, um Licht von der aktiven Schicht (3, 13) zwischen sich und der Substrat- oder Basisschicht (1) einzuschließen, und die Dicke der zweiten Auskleidungsschicht (2) mit Ausnahme des vorspringenden Abschnitts hinreichend schmal ist, um Licht von der aktiven Schicht (3) zu der Rückätzungsverhinderungsschicht (9) hindurchtreten zu lassen.

2. Licht emittierende Halbleitervorrichtung nach Anspruch 1, bei der die Rückätzungsverhinderungsschicht (9) eine $Ga_{1-x}Al_xAs$ $(0,1>x\geq0)$ Schicht ist.

3. Licht emittierende Halbleitervorrichtung nach Anspruch 1 oder 2, bei der die Dicke der Rückätzungsverhinderungsschicht (9) geringer als vier mal die Dicke der aktiven Schicht (3) ist.

4. Licht emittierende Halbleitervorrichtung nach einem der vorhergehenden Ansprüche, bei der die Dicke $h$ der Rückätzungsverhinderungsschicht (9) 0,1 µm oder mehr ist.

5. Licht emittierende Halbleitervorrichtung nach Anspruch 4, bei der die Dicke $l$ der zweiten Auskleidungsschicht (2) auf der Rückätzungsverhinderungsschicht (9) 0,2 bis 0,5 µm beträgt.

## Revendications

1. Dispositif à semiconducteur électroluminescent qui comprend une couche active (3, 13), une première couche métallisée (4) jointe à un côté de la couche active (3) et ayant une largeur de bande interdite supérieure à celle de la couche active (3), une seconde couche métallisée (2) jointe à l'autre côté de la couche active (3) et ayant une largeur de bande interdite supérieure à celle de la couche active (3), un type de conductivité opposé à celui de la première couche métallisée et comportant une partie saillante (2G) formée sur son côté opposé à la couche active (3), et une couche empêchant le passage d'un courant (8) entre la seconde couche métallisée (2) et un substrat ou une couche de base (1) du dispositif, de type de conductivité opposé à celui de la seconde couche métallisée (2) et du substrat ou de la couche de base (1), ce substrat ou cette couche de base (1) étant jointe à la partie saillante (2G) de la seconde couche métallisée (2),

caractérisé en ce que

une couche empêchant une attaque au dos (9) ayant une épaisseur inférieure à 0,4 µm est jointe à la seconde couche métallisée (2), à l'exception de la partie saillante (2G), sur le côté opposé de la seconde couche métallisée (2), et la couche empêchant le passage d'un courant (8) est jointe par un côté à la couche empêchant une attaque au dos (9) et par l'autre côté au substrat ou à la couche de base (1),

et en ce que

la couche empêchant le passage d'un courant (8) a une largeur de bande interdite ($E_2$) supérieure à celle ($E_3$) de la couche empêchant une attaque au dos (9) et supérieure à celle ($E_1$) du

substrat ou de la couche de base (1), et la couche empêchant une attaque au dos (9) a une largeur de bande interdite ($E_3$) inférieure à celle ($E_4$) de la seconde couche métallisée (2),

et en ce que

l'épaisseur de la partie saillante (2G) de la seconde couche métallisée (2) est suffisamment grande pour confiner la lumière provenant de la couche active (3, 13) entre celle-ci et le substrat ou la couche de base (1), et l'épaisseur de la seconde couche métallisée (2) à l'exception de la partie saillante est suffisamment petite pour permettre à la lumière provenant de la couche active (3) de pénétrer dans la couche empêchant une attaque au dos (9).

2. Dispositif à semiconducteur électroluminescent selon la revendication 1, dans lequel la couche empêchant une attaque au dos (9) est une couche de $Ga_{1-x}Al_xAs$ ($0,1 > x \geqslant 0$).

3. Dispositif à semiconducteur électroluminescent selon l'une quelconque des revendications 1 et 2, dans lequel l'épaisseur de la couche empêchant une attaque au dos (9) est inférieure à quatre fois l'épaisseur de la couche active (3).

4. Dispositif à semiconducteur électroluminescent selon l'une quelconque des revendications 1 à 3, dans lequel l'épaisseur $h$ de la couche empêchant une attaque au dos (9) est égale à 0,1 μm ou plus.

5. Dispositif à semiconducteur électroluminescent selon la revendication 4, dans lequel l'épaisseur $l$ de la seconde couche métallisée (2) sur la couche empêchant une attaque au dos (9) est comprise entre 0,2 et 0,5 μm.

FIG. 1

FIG. 2

FIG. 3

# FIG. 4

# FIG. 5

# FIG. 6

IG

I

# FIG. 7

2G

2

IG'     IG'

IG

I

# FIG. 8

6

5

4

d

3

9     3

8     2

2G

h l

1

7

# FIG. 9

REFRACTIVE INDEX

WITHIN STRIPE          OUTSIDE STRIPE

(a) $n_2$ $n_0$ $n_1$ n

(b) $n_2$ $n_0$ $n_1$ $n_3$ $n_4$ (c) LOSS

(d)  (e) ODD MODE  EVEN MODE (f)

# FIG. 12

FIG. 10

# FIG. 11

d = 0.1 (μm)

$\frac{\Delta n}{n} = 3 \times 10^{-3}$

h (μm)

ℓ (μm)

# FIG. 13